# EUROPÄISCHE PATENTSCHRIFT

(11) **EP 1 177 605 B1**
(45) Veröffentlichungstag und Bekanntmachung des Hinweises auf die Patenterteilung: **05.10.2005**
(21) Anmeldenummer: 00987065.0
(22) Anmeldetag: 02.11.2000
(51) Int. Cl.: H01S 5/022, H01S 5/40

(54) **LASERDIODENVORRICHTUNG UND HERSTELLUNGSVERFAHREN**
LASER DIODE DEVICE AND METHOD FOR PRODUCING THE SAME
DISPOSITIF A DIODE LASER ET PROCEDE PERMETTANT DE LE PRODUIRE

(30) Priorität: 02.11.1999 DE 19952712
(43) Veröffentlichungstag der Anmeldung: 06.02.2002
(73) Patentinhaber: Osram Opto Semiconductors GmbH & Co. OHG, 93049 Regensburg (DE)
(72) Erfinder: LUFT, Johann, 93195 Wolfsegg (DE); ACKLIN, Bruno, 93059 Regensburg (DE); HEERLEIN, Jörg, 93161 Sinzing (DE); SCHLERETH, Karl-Heinz, 93133 Burglengenfeld (DE); SPÄTH, Werner, 83607 Holzkirchen (DE); SPIKA, Zeljko, 93047 Regensburg (DE); HANKE, Christian, 81737 München (DE); KORTE, Lutz, 83620 Feldkirchen-Westerham (DE); EBELING, Karl, 89075 Ulm (DE); BEHRINGER, Martin, 93051 Regensburg (DE)
(74) Vertreter: Epping - Hermann - Fischer
(86) Internationale Anmeldenummer: PCT/DE2000/003852
(87) Internationale Veröffentlichungsnummer: WO 2001/033607

(56) Entgegenhaltungen:
- EP-A- 0 580 104
- WO-A-98/12757
- US-A- 5 212 706
- "905nm InGaAs pulsed laser diode - PGEW series" , EG&G OPTOELECTRONICS PRODUCT CATALOGUE, 1998 XP000998340 in der Anmeldung erwähnt das ganze Dokument
- YAMAMOTO N ET AL: "Surface mount type LD module with receptacle structure" ECTC, SAN DIEGO, JUNE 1999, Seiten 1129-1134, XP002166919 ISBN: 0-7803-5231-9

## Beschreibung

Die Erfindung betrifft eine Laserdiodenvorrichtung nach dem Oberbegriff des Patentanspruches 1. Sie betrifft weiterhin ein Verfahren zum Herstellen einer derartigen Laserdiodenvorrichtung.

Eine derartige Vorrichtung ist aus der Veröffentlichung EG&G Optoelectronics: Pulsed Laserdiodes - PGEW Series, Internet-Veröffentlichung, bekannt. Ein Laserdiodenchip erreicht eine Ausgangsleistung von 15 Watt und ist in ein Plastikgehäuse eingebaut. Die Pulsdauer des Laserdiodenelements beträgt 30ns. Der Aufbau des Laserdiodenchips entspricht grundsätzlich einer Mehrfach-Quantum-Well-Struktur.

Derartige übliche Laserchips mit einer einfachen aktiven Zone, meistens mit Quantum-Well Struktur, auch in LOC(large optical cavity)-Technik werden für den Laserleistungsbereich von 1 bis 15 W und Pulsdauern von 5 bis 100ns oder bei Pulsdauern bis zu einigen Mikrosekunden mit niedrigeren Leistungen eingesetzt. Aus Kostengründen wird der Laserchip in ein übliches LED-Gehäuse für eine lichtemitierende Diode eingebaut. Anschließend wird der Chip beispielsweise mit Harz vergossen.

Für benötigte Ausgangsleistungen über 15 W bis etwa 50 W sieht die vorgenannte Veröffentlichung die Montage mehrerer Laserdiodenchips nebeneinander in demselben Gehäuse vor. Derart hohe optische Ausgangsleistungen aus Laserdioden im Kurzpulsbereich werden für eine Vielzahl von Anwendungen benötigt. Typische Anwendungen sind Einbruchalarm- und Kollisionsvermeidungssysteme, LIDAR, optische Entfernungsmessung, Freiraumübertragung u.s.w.

Die vorstehend beschriebene Mehrfachchip-Laserdiodenvorrichtung ist für viele Anwendungen ungünstig und darüber hinaus aufwendig und deshalb teuer. Zum einen ist eine derartige Montage mehrerer Chips in einem LED-Gehäuse in den für die Massenfertigung von LEDs vorgesehenen LED-Herstellungslinien nicht üblich und nur schwer auf diesen Linien implementierbar, zum anderen ist die Lösung wegen der großen benötigten Chipfläche teuer. Bei Verdreifachung der Ausgangsleistung sind beispielsweise drei Laserdiodenelemente erforderlich. Schließlich wird bei den im Gehäuse nebeneinander angeordneten Chips die nach außen wirksame Strahlungsquelle auf mehrere relativ weit auseinanderliegende Emitter verteilt, was zu verschlechterten Abbildungseigenschaften führt. Die Montage eines Halbleiterchips in ein LED-Gehäuse mit einer wellenlängenkonvertierenden Vergußmasse ist in der Druckschrift WO98/12747 beschrieben.

Für hohe Laserausgangsleistungen ist es andererseits bekannt, Stapel aus Diodenlaserbarren zu verwenden. Dadurch werden die Leistungen der Diodenlaser zusammengeschaltet. Um bei den hohen optischen Ausgangsleistungen die damit verbundenen thermischen Leistungen kontrollieren zu können, werden die Laserdiodenbarren oft auf Kühler montiert und die Bauelemente in Kombination eingesetzt. Das ist technisch sehr aufwendig, und durch den großen Abstand der einzelnen Strahlungsemitter ebenso wie durch die größere Emitterfläche verschlechtert sich die Fokussierbarkeit des Laserlichts. Durch die Größe der montierten Barren ergeben sich Schwierigkeiten bei der Kombination mehrerer Strahlungsemitter übereinander und darüberhinaus eine Reduzierung der Strahlqualität. Eine derartige Anordnung von Laserdiodenbarren ist aus einer Veröffentlichung der Firma DILAS Diodenlaser GmbH, Mainz-Hechtsheim bekannt.

Weiterhin ist aus der Druckschrift EP 0 580 104 A2 ein Halbleiterlaser mit übereinander angeordneten aktiven Schichten bekannt, die über eine Tunneldiode miteinander verbunden sind.

Der Erfindung liegt die Aufgabe zugrunde, eine kostengünstige, für die Herstellung in Großserie geeignete Laserdiodenvorrichtung mit hoher Leistung und ein Verfahren zu deren Herstellung anzugeben.

Diese Aufgabe wird durch eine Laserdiodenvorrichtung mit den Merkmalen des Patentanspruches 1, durch eine Verwendung gemäß Anspruch 6 und durch ein Verfahren mit den Merkmalen des Patentanspruches 7 oder 8 gelöst. Vorteilhafte Weiterbildungen sind Gegenstand der Unteransprüche 2 bis 5.

Die vorliegende Erfindung sieht eine Laserdiodenvorrichtung vor, bei der in ein LED-Gehäuse ein Laserdiodenchip eingebaut ist, der als Mehrfachstrahl-Halbleiterlaserdiode aufgebaut ist, die auf einem Halbleitersubstrat eine Mehrzahl übereinander angeordneter Laserstapel mit jeweils mindestens einer aktiven Schicht aufweist, bei der wenigstens ein paar benachbarter Laserstapel einen dazwischen angeordneten Tunnelübergang hat, und bei der die äußeren Oberflächen des Halbleitersubstrats und des obersten Laserstapels jeweils einen Anschlußkontakt haben, die mit den Anschlüssen des LED-Gehäuses verbunden sind. Die Laserdiodenvorrichtung ist für einen Pulsbetrieb mit Pulsdauern von 1 ns bis 25 ns vorgesehen.

Durch die Verwendung monolithischer Laserdiodenstapel sind einerseits außerordentlich hohe optische Ausgangsleistungen bis 200 W oder sogar darüber hinaus im Kurzpulsbereich möglich, andererseits entspricht die verwendete Chipfläche derjenigen einer Einzellaserdiode. Es ist deshalb nur ein einziger Chip in das Gehäuse zu montieren. Die Chipkosten einer derartigen Struktur liegen erheblich niedriger als die Kosten für mehrere Chips mit insgesamt gleicher Ausgangsleistung. Durch die Montage nur eines Chips kann die Laserdiodenvorrichtung sehr kostengünstig auf einer Standard-Herstellungslinie für LED-Bauelemente erfolgen. Darüberhinaus liegen die Lichtemitter einer derartigen Mehrfachstrahl-Laserdiode eng beieinander, so dass eine Fokussierung des Laserlichts leicht möglich ist. Weiterhin ergeben sich Vorteile bei der unfokussierten Strahlqualität.

Es ist vorgesehen, dass die Mehrfachstrahl-Laserdiode vom Typ eines Kantenemitters oder eines Oberflächenemitters ist. Der Aufbau einer derartigen Mehrfachstrahl-Laserdiode kann eine Einfach- oder Mehrfach-Quantum-Well-Struktur oder eine DFB-Struktur haben.

Nach dem Einbau der Mehrfachstrahl-Laserdiode kann die Laserdiode mit einem transparenten Material vergossen werden, z. B. Harz oder Silikon.

Je nach Typ des LED-Gehäuses ist vorgesehen, dass die Mehrfachstrahl-Laserdiode in einer oder in zwei Richtungen abstrahlt. Der oder die Ausgangstrahlen der Mehrfachstrahl-Laserdiode können direkt oder über Spiegel aus dem Gehäuse ausgekoppelt werden. Dadurch ergeben sich Laserdiodenvorrichtungen, die bei einer Montage der Vorrichtung auf einer Platine nach oben oder zur Seite abstrahlen können. Besonders vorteilhaft eignen sich hier LED-Gehäuse, die für die Oberflächenmontage vorgesehen sind.

Die Erfindung wird nachfolgend anhand der Figuren der Zeichnung näher erläutert. Es zeigen:
- Fig. 1: eine schematische Schnittdarstellung einer in ein LED-Gehäuse für die Oberflächenmontage eingebaute Mehrfachstrahl-Hochleistungslaserdiode
- Fig. 2: eine schematische perspektivische Ansicht einer Mehrfachstrahl-Hochleistungslaserdiode für ein Radial-LED-Gehäuse
- Fig. 3: eine schematische perspektivische Ansicht einer Mehrfachstrahl-Hochleituntslaserdiode in einem Radial-Gehäuse
- Fig. 4: den schematischen Schichtaufbau einer Mehrfachstrahl-Hochleistungslaserdiode.

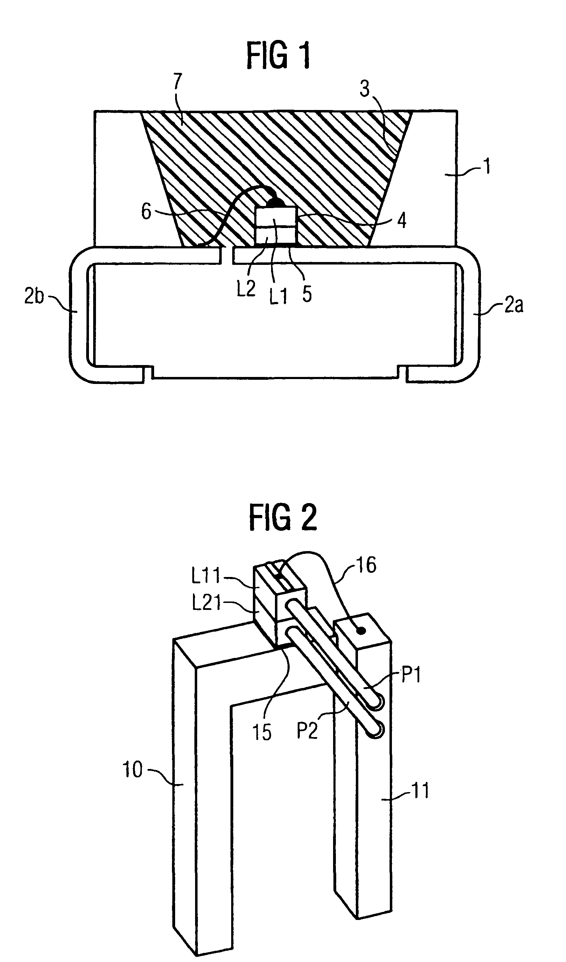

Figur 1 zeigt einen Querschnitt durch ein LED-Gehäuse für die Oberflächenmontage (Gehäuse nach IEC-Publ. 286 Teil 3). Der Gehäusekörper 1 besteht aus hochtemperaturfestem Thermoplast, mit dem ein endlosgestanztes Leiterband 2a und 2b umspritzt ist. Das Gehäuse hat innen eine Öffnung, deren Seiten 3 als Reflektorfläche ausgebildet sind. Der Halbleiterchip 4 mit dem Aufbau einer Mehrfachstrahl-Laserdiode mit den im Ausführungsbeispiel zwei Laserstapeln L1 und L2, zwischen denen ein nicht näher bezeichneter Tunnelübergang angeordnet ist, ist mit einem ersten ohmschen Kontakt 5 auf einem Anschlussteil 2a des Gehäuses elektrisch leitend aufgebracht. Der elektrische Kontakt 5 ist auf der unteren Oberfläche des Halbleitersubstrats der Mehrfachstrahl-Laserdiode aufgebracht. Ein auf dem obersten Laserstapel L1 aufgebrachter zweiter ohmscher Kontakt 6 ist mit dem anderen Teil des Anschluss-Leiterbands 2b elektrisch leitend verbunden.

Der die Mehrfachstrahl-Laserdiode enthaltende Halbleiterchip 4 kann so ausgebildet sein, dass die beiden Laserstrahlen der Laserstapel L1 und L2 über eine Kante der aktiven Schichten oder über beide Kanten ausgekoppelt werden. Mit Hilfe der Reflektorfläche 3 werden die Einzelstrahlen umgelenkt und nach oben aus dem Gehäuse ausgekoppelt. Zur Verbesserung der Lichtauskopplung und zum Schutz der montierten Laserdiode vor Umwelteinflüssen ist die Reflektoröffnung mit Epoxyharz 7 vergossen. Das Harz 7 und der Gehäusewerkstoff sind sorgfältig aufeinander abgestimmt, damit auch bei thermischen Spitzenbelastungen keine mechanischen Störungen auftreten können. Anstelle des Gießharzes 7 kann auch ein anderes transparentes Material eingesetzt werde, beispielsweise Acrylharz, Silikon o.ä..

Eine Vorrichtung gemäß Figur 1 mit einer in ein LED-Gehäuse montierten Mehrfachstrahl-Laserdiode ist im Kurzpulsbereich mit einer Pulsdauer zwischen 1 ns und 25 ns bis 200 W und darüber hinaus betreibbar. Da die Chipfläche der übereinandergestapelten Laserdioden derjenigen einer einzigen Einzellaserdiode entspricht und nur ein Chip 4 montiert zu werden braucht, kann die Montage des Halbleiterchips in das Gehäuse auf einer Standard-Herstellungslinie für LEDs sehr kostengünstig erfolgen.

Die monolithischen Mehrfachstrahl-Laserdioden mit übereinander angeordneten Laserstapeln, beispielsweise den Stapeln L1 und L2, sind für Pulsbetrieb geeignet und enthalten mindestens zwei aktive Laserzonen, die mit Hilfe eines Übergangs miteinander verbunden sind. Bei dem Übergang handelt es sich z. B. um einen Halbleiter-Tunnelübergang. Die Laserstapel können Einfach- oder Mehrfach-Quantum-Well-Strukturaufbau oder einen anderen Aufbau besitzen. Die Schichten werden typischerweise epitaktisch übereinander abgeschieden. Übliche vertikale Abstände zwischen zwei benachbarten Lichtemittern betragen 2-3 µm. Im Betrieb sind dabei die einzelnen übereinander angeordneten Laserstapel in Serie geschaltet. Im Vergleich zu Einzellaserdioden mit der gleichen Ausgangsleistung, die mit verschiedenen Einzel-Halbleiterchips realisiert ist, ergeben sich bei der Mehrfachstrahl-Laserdiode auch Vorteile hinsichtlich der Fokussierbarkeit der Laserstrahlen und hinsichtlich der Strahlqualität.

Figur 2 zeigt eine teilperspektivische Ansicht einer Mehrfachstrahl-Laserdiode mit den Laserstapeln L11 bzw. L21, die auf einem Anschlußteil 10 für eine Radial-LED montiert sind. Die Verbindung erfolgt über den ohmschen Anschlußkontakt 15 unterhalb des Substrats. Der andere Anschlußkontakt der Mehrfachstrahl-Laserdiode oberhalb des obersten Laserstapels L11 ist mit dem Anschluß 16 mit einem zweiten Aussenanschluß 11 der Vorrichtung verbunden. Schematisch angedeutet sind die Laserpulse P1 und P2, die von den Laserstapeln L11 bzw. L21 ausgesandt werden. Die Vorrichtung der Figur 2 wird anschließend typischerweise mit einem transparenten Material vergossen.

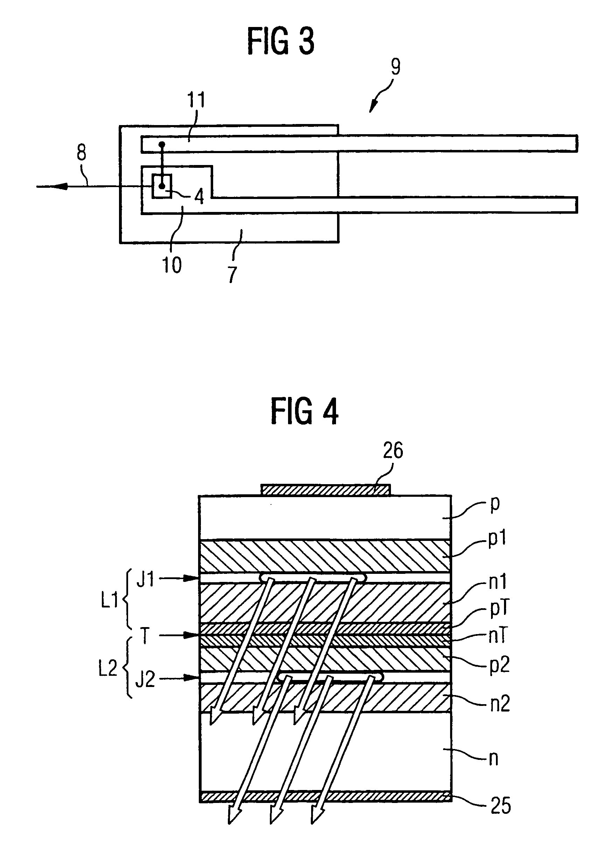

Figur 3 zeigt ein besonders bevorzugtes Ausführungsbeispiel, bei dem ein kantenemittierender Mehrfachstrahl-Hochleistungslaserdiodenchip 4 auf die Seitenfläche des Anschlußteiles 10 eines aus der Lumineszenzdiodenbauelement-Technologie bekannten Radialgehäuses 9 montiert ist und die Abstrahlrichtung 8 parallel zu den Anschlußbeinchen des Radialgehäuses 9 verläuft. Der kantenemittierende Hochleistungslaserdiodenchip 4 wird in diesem Fall zunächst auf eine Seitenfläche des Anschlußteiles montiert und nachfolgend unmittelbar mit dem strahlungsdurchlässigen Reaktionsharz 7 vergossen.

Figur 4 zeigt beispeilhaft den Aufbau einer Mehrfachstrahl-Laserdiode, wie er in der US 5,212,706 beschrieben ist. Die Mehrfachstrahl-Laserdiode enthält die übereinander angeordneten Laserstapel L1 und L2, zwischen denen ein aus den Schichten nT und pT gebildeter Tunnelübergang T liegt. Der untere Laserstapel L2 enthält die Schichten n2 und p2, die durch eine aktive Schicht J2 getrennt sind. Der Schichtaufbau befindet sich oberhalb des Substrats n, das auf seiner Unterseite einen ohmschen Anschlußkontakt 25 aufweist. Der obere Laserstapel L1 umfasst die Diodenschichten p1 und n1, die durch eine aktive Schicht J1 getrennt sind. Typischerweise sind die Tunnelschichten nT und pT hochdotierte n- bzw. p-Schichten. Oberhalb des oberen Laserstapels L1 ist eine Halbleiterschicht p vorhanden, auf deren Oberfläche sich eine zweiter ohmscher Anschlußkontakt 26 befindet.

Aufbau und Funktion der Mehrfachstrahl-Laserdiode sind in der zuvor zierten US Patenschrift ausführlich diskutiert. Dabei handelt es sich um ein GaAs-System. Es versteht sich, dass auch Mehrfachstrahl-Laserdioden in anderen Materialsystemen realisiert werden können, beispielsweise im InGaAs-System. Ein derartiger Aufbau ist z.B. durch zwei einzelne Doppel-Quantum-Well-Strukturen (DQW) möglich, die in einer LOC-Wellenleiterstruktur aus AlGaAs eingebettet sind und über einen im Galliumarsenid plazierten Tunnelübergang miteinander verbunden sind. Die zentrale Emissionswellenlänge einer derartigen Anordnung hängt von der Dimensionierung der DQW-Struktur ab und liegt beispielsweise bevorzugt bei 905 nm.

Mehrfachstrahl-Laserdioden als Pulslaser sind im gesamten mit den durch die III-/V-Verbindungshalbleiter abgedeckten Wellenlängenbereich von UV bis oberhalb 1,5 µm möglich. Insbesondere sind die Wellenlängenbereiche um 850 nm und um 905 nm technisch von großen Interesse. Hierzu zählen insbesondere Direktanwendungen im gepulsten Betrieb. Auch bei hohen optischen Ausgangsleistungen ist für die Mahrfachstrahl-Laserdioden im Pulsbetrieb die thermische Belastung gering, so dass die monolithisch gestapelten Laserdioden keiner schnellen Degradation unterliegen. Dadurch wird es ermöglicht, die Vorteile der hohen Laserausgangsleistungen bei vergleichbar guter Strahlqualität auch in einem einfachen LED-Gehäuse zu nutzen, ohne die Nachteile bekannter Stapelbarren oder einer hohen Wärmeerzeugung im Kauf nehmen zu müssen.

Die Ausgangsleistungen der Mehrfachstrahl-Laserdioden betragen je nach der Anzahl der übereinander liegenden Laserstapel etwa 70 W bei zwei übereinander liegenden Laserstapeln und 100 W bei drei übereinander liegenden Laserstapeln. Ein in dem zuvor beschriebenen Materialsystem InGaAs für die Wellenlänge 905 nm prozessierter 20-Streifenarray-Chip hat die Abmessungen 600 x 600 µm2 und wird in ein übliches LED-Gehäuse mit Refektorwanne montiert und vergossen (vergleiche Figur 1). Die Ausgangsleistung beträgt ca. 70 W und die differenzielle Steilheit der Strom-Strahlungskennlinie ist > 2.0 W/A. Werden im selben System drei Doppel-Quantum-Well-Laserstrukturen übereinander gewachsen, ergibt sich eine Mehrfachstrahl-Laserdiode mit einer Ausgangsleistung von etwa 100 W und einer Steilheit der Kennlinie von > 3 W/A. Es ist möglich, Mehfachstrahl-Laserdioden herzustellen, die noch höhere Ausgangsleistungen bis weit über 100 W haben.

## Patentansprüche

1. Laserdiodenvorrichtung mit einem Hochleistungs-Laserdiodenchip, bei der
- der Hochleistungs-Laserdiodenchip (4) einen Aufbau als Mehrfachstrahl-Laserdiode (L1, L2) hat, die auf einem Halbleitersubstrat (n) mindestens zwei übereinander angeordnete Laserstapel (L1, L2) mit jeweils mindestens einer aktiven Schicht (J1, J2), zwischen denen ein Tunnelübergang (T) angeordnet ist, und elektrische Anschlußkontakte (25, 26) aufweist,
- der Hochleistungs-Laserdiodenchip (4) auf einem Anschlußteil (2a,10) eines Leiterbandes montiert ist,
- die elektrischen Anschlußkontakte (25,26) mit Anschlußteilen (2a,2b,10,11) des Leiterband elektrisch leitend verbunden sind,
- der Hochleistungs-Laserdiodenchip (4) und zumindest teilweise die Anschlußteile (2a,2b,10,11) mit einem strahlungsdurchlässigen Reaktionsharz vergossen sind, und
- der Hochleistungs-Laserdiodenchip (4) gepulst mit einer Pulsbreite zwischen 1 ns und 25 ns betrieben wird.

2. Laserdiodenvorrichtung nach Anspruch 1, bei der der Abstand zwischen den beiden benachbarten Strahlungsemittern zwischen einschließlich 2µm und einschließlich 3µm beträgt.

3. Laserdiodenvorrichtung nach einem der Ansprüche 1 oder 2, bei der die Anschlußteile (2a,2b) mit einem oberflächenmontierbaren Gehäusekörper (1) versehen sind, der eine Ausnehmung aufweist, in der zumindest jeweils ein Teilbereich der Anschlußteile (2a,2b) freiliegen, in der der Hochleistungs-Laserdiodenchip (4) auf dem Anschlußteil (2a) montiert ist und in der der Laserdiodenchip (4) mit dem strahlungsdurchlässigen Reaktionsharz vergossen ist.

4. Laserdiodenvorrichtung nach Anspruch 3, bei der die Emissionsrichtung des Hochleistungs-Laserdiodenchips (4) parallel zu einer Bodenfläche der Ausnehmung verläuft, auf der der Laserdiodenchip montiert ist, und die Seitenwände der Ausnehmung zusammen mit der Bodenfläche eine Reflektorwanne (3) ausbilden und die Seitenflächen verspiegelt sind.

5. Laserdiodenvorrichtung nach einem der Ansprüche 1 bis 3, bei dem der Laserdiodenchip (4) in Bezug auf das Gehäuse derart angeordnet ist, dass die Ausgangsstrahlen (P1, P2) der Mehrfachstrahl-Laserdiode (4) ohne Umlenkung aus dem Gehäuse abgestrahlt werden.

6. Verwendung von Reaktions-Gießharz, insbesondere Epoxidharz, Acrylharz oder Silikonharz oder ein Gemisch dieser Materialien, zum Vergießen eines gepulst mit eine Pulsbreite zwischen 1 ns und 25 ns betriebenen Hochleistungs-Laserdiodenchips, der den Aufbau einer Mehrfachstrahl-Laserdiode (L1, L2) aufweist, die auf einem Halbleitersubstrat (n) mindestens zwei übereinander angeordnete Laserstapel (L1, L2) mit jeweils mindestens einer aktiven Schicht (J1, J2) enthält, zwischen denen ein Tunnelübergang (T) angeordnet ist, und der auf einem Anschlußteil (2a,10) eines Leiterbandes montiert ist.

7. Verfahren zum Herstellen einer Laserdiodenvorrichtung gemäß einem der Patentansprüche 3 bis 5, bei dem die Anschlußteile (2a,2b) des Leiterbandes mit einem Gehäusekörper (1) versehen werden, der eine Ausnehmung aufweist, innerhalb der der Hochleistungslaserdiodenchip (4) auf dem zugehörigen Anschlußteil (2a) montiert wird und bei dem nachfolgend der Hochleistungslaserdiodenchip (4) mit dem transparenten Reaktionsharz vergossen wird.

8. Verfahren zum Herstellen einer Laserdiodenvorrichtung gemäß einem der Patentansprüche 1 oder 2, beim dem der Hochleistungslaserdiodenchip (4) mit einem aus der Lumineszenzdiodenbauelement-Technologie bekannten Radialgehäuse versehen wird, wobei der kantenemittierende Hochleistungslaserdiodenchip (4) zunächst auf eine Seitenfläche des Anschlußteiles montiert wird und nachfolgend unmittelbar mit dem strahlungsdurchlässigen Reaktionsharz vergossen wird.

## Claims

1. Laser diode device with a high-power laser diode chip, in which
- the high-power laser diode chip (4) has a construction as a multiple-beam laser diode (L1, L2) having, on a semiconductor substrate (n), at least two laser stacks (L1, L2) arranged one above the other with in each case at least one active layer (J1, J2), between which a tunnel junction (T) is arranged, and electrical connection contacts (25, 26),
- the high-power laser diode chip (4) is mounted on a connection part (2a, 10) of a leadframe,
- the electrical connection contacts (25, 26) are electrically conductively connected to connection parts (2a, 2b, 10, 11) of the leadframe,
- the high-power laser diode chip (4) and at least partly the connection parts (2a, 2b, 10, 11) are potted with a radiation-transmissive reaction resin, and
- the high-power laser diode chip (4) is operated in pulsed fashion with a pulse width of between 1 ns and 25 ns.

2. Laser diode device according to Claim 1, in which the distance between the two adjacent radiation emitters is between 2 µm and 3 µm inclusive.

3. Laser diode device according to either of Claims 1 and 2, in which the connection parts (2a, 2b) are provided with a surface-mountable housing body (1) having a cutout in which at least one partial region of the connection parts (2a, 2b) in each case is uncovered, in which the high-power laser diode chip (4) is mounted on the connection part (2a) and in which the laser diode chip (4) is potted with the radiation-transmissive reaction resin.

4. Laser diode device according to Claim 3, in which the emission direction of the high-power laser diode chip (4) runs parallel to a bottom area of the cutout on which the laser diode chip is mounted, and the sidewalls of the cutout together with the bottom area form a reflector well (3) and the side areas are mirror-coated.

5. Laser diode device according to one of Claims 1 to 3, in which the laser diode chip (4) is arranged in relation to the housing in such a way that the output beams (P1, P2) of the multiple-beam laser diode (4) are emitted without deflection from the housing.

6. Use of reaction casting resin, in particular epoxy resin, acrylic resin or silicone resin or a mixture of these materials, for the potting of a high-power laser diode chip which is operated in pulsed fashion with a pulse width of between 1 ns and 25 ns and has the construction of a multiple-beam laser diode (L1, L2) containing, on a semiconductor substrate (n), at least two laser stacks (L1, L2) arranged one above the other with in each case at least one active layer (J1, J2), between which a tunnel junction (T) is arranged, and which is mounted on a connection part (2a, 10) of a leadframe.

7. Method for producing a laser diode device according to one of Patent Claims 3 to 5, in which the connection parts (2a, 2b) of the leadframe are provided with a housing body (1) having a cutout within which the high-power laser diode chip (4) is mounted on the associated connection part (2a), and in which the high-power laser diode chip (4) is subsequently potted with the transparent reaction resin.

8. Method for producing a laser diode device according to either of Patent Claims 1 and 2, in which the high-power laser diode chip (4) is provided with a radial housing known from luminescence diode component technology, the edge-emitting high-power laser diode chip (4) firstly being mounted onto a side area of the connection part and subsequently being directly potted with the radiation-transmissive reaction resin.

## Revendications

1. Dispositif à diodes lasers avec une puce à diodes lasers de forte puissance, tel que
- la puce à diodes lasers de forte puissance (4) a une structure de diode laser à faisceaux multiples (L1, L2) qui comporte sur un substrat semi-conducteur (n) au moins deux empilements lasers superposés (L1, L2) avec à chaque fois au moins une couche active (J1, J2), une jonction tunnel (T) étant prévue entre lesdites couches actives, et des contacts de connexion électriques (25, 26),
- la puce à diodes lasers de forte puissance (4) est montée sur une partie de connexion (2a, 10) d'une bande conductrice,
- les contacts de connexion électriques (25, 26) sont reliés de façon électriquement conductrice à des parties de connexion (2a, 2b, 10, 11) de la bande conductrice,
- la puce à diodes lasers de forte puissance (4) et au moins partiellement les parties de connexion (2a, 2b, 10, 11) sont scellées avec une résine composite transparente au rayonnement, et
- la puce à diodes lasers de forte puissance (4) est exploitée selon un mode pulsé avec une largeur d'impulsion comprise entre 1 ns et 25 ns.

2. Dispositif à diodes lasers selon la revendication 1, tel que l'écart entre les deux émetteurs de rayonnement voisins est compris entre 2 µm inclus et 3 µm inclus.

3. Dispositif à diodes lasers selon l'une des revendications 1 ou 2, tel que les parties de connexion (2a, 2b) sont munies d'un corps de boîtier (1) qui peut être monté en surface et qui comporte un évidement dans lequel est dégagée au moins à chaque fois une zone partielle des parties de connexion (2a, 2b) dans laquelle la puce à diodes lasers de forte puissance (4) est montée sur la partie de connexion (2a) et dans laquelle la puce à diodes lasers (4) est scellée avec la résine composite transparente au rayonnement.

4. Dispositif à diodes lasers selon la revendication 3, tel que la direction d'émission de la puce à diodes lasers de forte puissance (4) s'étend parallèlement à une surface de fond de l'évidement sur laquelle la puce à diodes lasers est montée et tel que les parois latérales de l'évidement forment conjointement avec la surface de fond une cuvette de réflexion (3) et que les parois latérales sont traitées pour être réfléchissantes.

5. Dispositif à diodes lasers selon l'une des revendications 1 à 3, tel que la puce à diodes lasers (4) est disposée de telle sorte par rapport au boîtier que les faisceaux de sortie (P1, P2) de la diode laser à faisceaux multiples (4) sont émis sans déviation hors du boîtier.

6. Utilisation de résine composite de scellement, notamment de résine époxy, de résine acrylique ou de résine de silicone ou d'un mélange de ces matériaux, pour sceller une puce à diodes lasers de forte puissance qui fonctionne en mode pulsé avec une largeur d'impulsion comprise entre 1 ns et 25 ns, qui présente la structure d'une diode laser à faisceaux multiples (L1, L2) contenant sur un substrat semi-conducteur (n) au moins deux empilements lasers superposés (L1, L2) avec à chaque fois au moins une couche active (J1, J2), une jonction tunnel (T) étant prévue entre lesdites couches actives, et qui est montée sur une partie de connexion (2a, 10) d'une bande conductrice.

7. Procédé de fabrication d'un dispositif à diodes lasers selon l'une des revendications 3 à 5, dans lequel les parties de connexion (2a, 2b) de la bande conductrice sont munies d'un corps de boîtier (1) qui comporte un évidement à l'intérieur duquel la puce à diodes lasers de forte puissance (4) est montée sur la partie de connexion associée (2a) et dans lequel la puce à diodes lasers de forte puissance (4) est scellée ensuite avec la résine composite transparente.

8. Procédé de fabrication d'un dispositif à diodes lasers selon l'une des revendications 1 ou 2, dans lequel la puce à diodes lasers de forte puissance (4) est munie d'un boîtier radial connu par la technique des composants à diodes électroluminescentes, la puce à diodes lasers de forte puissance (4) émettant par les arêtes étant d'abord montée sur une surface latérale de la partie de connexion et étant ensuite scellée directement avec la résine composite transparente au rayonnement.
